**Europäisches Patentamt**

(19) **European Patent Office**

**Office européen des brevets**

(11) Veröffentlichungsnummer: **0 157 937**
**B1**

(12) **EUROPÄISCHE PATENTSCHRIFT**

(45) Veröffentlichungstag der Patentschrift:
02.09.87

(51) Int. Cl.⁴: **H 03 K 17/56,** H 03 K 17/04

(21) Anmeldenummer: **84115589.8**

(22) Anmeldetag: **17.12.84**

(54) **Elektronischer Schalter.**

(30) Priorität: **11.04.84 DE 3413666**

(43) Veröffentlichungstag der Anmeldung:
**16.10.85 Patentblatt 85/42**

(45) Bekanntmachung des Hinweises auf die Patenterteilung:
**02.09.87 Patentblatt 87/36**

(84) Benannte Vertragsstaaten:
**AT CH DE FR GB IT LI NL SE**

(56) Entgegenhaltungen:
EP-A-0 063 749
GB-A-2 105 927

**SOLID-STATE ELECTRONICS, Band 25, Nr. 5, 1982, Oxford; GB; B.J. BALIGA "High gain power switching using field controlled thyristors", pages 345-353**

(73) Patentinhaber: **Siemens Aktiengesellschaft Berlin und München, Wittelsbacherplatz 2, D-8000 München 2 (DE)**

(72) Erfinder: **Strack, Helmut, Dr. phil., Speyerer Strasse 6, D-8000 München 40 (DE)**

## Beschreibung

Die vorliegende Erfindung bezieht sich auf einen elektronischen Schalter mit einem Thyristor mit vier Zonen abwechselnden Leitungstyps, dem katodenseitig ein erster IGFET in Reihe geschaltet ist.

Ein solcher Schalter ist beispielsweise in der Zeitschrift "Solid State Electronics", Band 25, Nr. 5, Seiten 345 bis 353, 1952, insbesondere Fig. 3, beschrieben worden. Der Thyristor ist hier ein spezieller feldgesteuerter Thyristor mit einer an Masse liegenden Gate-Elektrode. Zum Abschalten des elektronischen Schalters wird der IGFET gesperrt. Dann fließt der durch die im Thyristor gespeicherten Ladungsträger verursachte Strom durch die Gate-Elektrode nach Masse. Ein Nachteil dieses Schalters besteht darin, daß nach dem Abschalten des IGFET weiterhin so lange Ladungsträger aus der anodenseitigen Emitterzone in die Innenzonen des Thyristors fließen, wie der pn-Übergang zwischen anodenseitiger Emitterzone und anodenseitiger Basiszone in Durchlaßrichtung vorgespannt ist. Damit wird die Menge der auszuräumenden Ladungsträger erhöht. Die Freiwerdezeit ist entsprechend hoch und das Abschalten wird verzögert.

Der Erfindung liegt die Aufgabe zugrunde, einen elektronischen Schalter der eingangs erwähnten Gattung so weiterzubilden, daß ein wesentlich schnelleres Abschalten möglich ist. Diese Aufgabe wird gelöst durch die Merkmale:

a) dem Thyristor ist anodenseitig ein zweiter IGFET in Reihe geschaltet,

b) der zweite IGFET ist zwischen der äußeren anodenseitigen Zone und einer ersten Klemme des Schalters angeschlossen,

c) der erste IGFET ist zwischen der äußeren katodenseiseitigen Zone und einer zweiten Klemme des Schalters angeschlossen,

d) die innere anodenseitige und die innere katodenseitige Zone sind mit je einem Anschluß versehen,

e) zwischen dem Anschluß der inneren anodenseitigen Zone und der ersten Klemme ist ein erstes Schwellwertglied angeschlossen,

f) zwischen dem Anschluß der inneren katodenseitigen Zone und der zweiten Klemme ist ein zweites Schwellwertglied angeschlossen,

g) die Schwellwertglieder haben eine höhere Schwellspannung als die pn-Übergänge zwischen den beiden anodenseitigen bzw. katodenseitigen Zonen zuzüglich des Durchlaßwiderstandes des mit der äußeren anodenseitigen bzw. katodenseitigen Zone verbundenen IGFET.

Weiterbildungen der Erfindung sind Gegenstand der Unteransprüche.

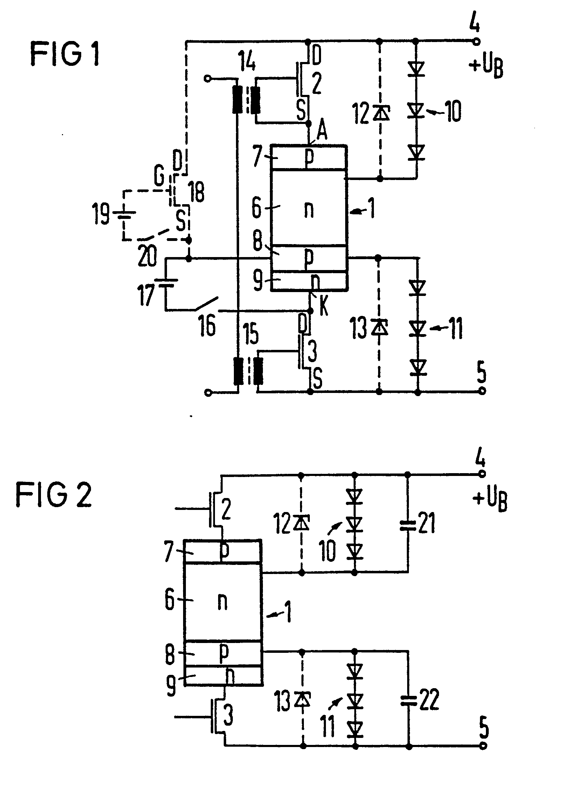

Die Erfindung wird anhand zweier Ausführungsbeispiele in Verbindung mit den Figuren 1 und 2 näher erläutert. Diese Figuren zeigen zwei Schaltbilder gemäß der Erfindung.

Der elektronische Schalter nach Fig. 1 enthält einen Thyristor 1 mit vier Zonen abwechselnden Leitungstyps. Die Zonenfolge sei ausgehend vom Katodenanschluß K zum Anodenanschluß A npnp. Mit dem Anodenanschluß A ist die Source-Drain-Strecke eines ersten IGFET 2 verbunden. Mit dem Katodenanschluß K ist die Source-Drain-Strecke eines zweiten IGFET 3 verbunden. Die nicht mit dem Thyristor verbundenen Anschlüsse der IGFET 2 und 3 liegen an einer ersten Klemme 4 bzw. einer zweiten Klemme 5. Bezüglich dieser Klemmen sind die IGFET dem Thyristor in Reihe geschaltet. Der Thyristor 1 weist eine innere anodenseitige Zone 6, eine äußere anodenseitige Zone 7, eine innere katodenseitige Zone 8 und eine äußere katodenseitige Zone 9 auf. Die inneren Zonen 6 und 8 sind jeweils mit einem Anschluß versehen. Der Gate-Anschluß an der Zone 8 ist bei Thyristoren allgemein üblich. Der Anschluß der Zone 6 läßt sich ohne weiteres z. B. durch eine in der Zone 7 vorgesehene Aussparung herstellen. Zwischen der Zone 6 und der ersten Klemme 4 liegt ein erstes Schwellwertglied 10. Zwischen der Zone 8 und der zweiten Klemme 5 liegt ein zweites Schwellwertglied 11. Diese Schwellwertglieder haben eine Schwellspannung, die höher ist als die Schwellspannungen der pn-Übergänge zwischen den Zonen 6 und 7 bzw. 8 und 9 zuzüglich der Durchlaßspannung des IGFET 2 bzw. 3. Die Schwellwertglieder 10, 11 können beispielsweise aus einer Anzahl in Reihe geschalteter Dioden oder je einer Zenerdiode 12, 13 bestehen. Die Dioden sind bezüglich einer angelegten Spannung $+U_B$ in Durchlaßrichtung geschaltet. Die Zenerdioden 12, 13 sind so geschaltet, daß sie von der genannten Spannung in Durchbruchrichtung beansprucht werden.

Durch Einschalten der IGFET 2, 3 wird der Thyristor an die Spannung $+U_B$ gelegt. Die IGFET können beispielsweise durch Übertrager 14, 15 angesteuert werden. Es ist auch möglich, die IGFET durch einen Optokoppler oder einen Piezo-Koppler potentialfrei anzusteuern, wie dies beispielsweise in der Zeitschrift "Siemens Components", 20 (1982) Heft 1, Seiten 8 bis 13, insbesondere Bild 1, dargestellt ist. Der Thyristor 1 kann gezündet werden, indem der pn-Übergang zwischen den Zonen 8 und 9 in Durchlaßrichtung vorgespannt wird. Dies kann beispielsweise durch eine Spannungsquelle 17 geschehen, die über einen Schalter 16 an die Zonen 8 und 9 angelegt wird. Selbstverständlich lassen sich auch andere Möglichkeiten der Zündung des Thyristors 1 einsetzen. So kann die Zone 8 beispielsweise über die Source- Drain-Strecke eines weiteren IGFET 18 mit der Klemme 4 verbunden werden. Der IGFET 18 wird dann über einen Schalter 20 gesteuert, durch den die Spannung einer Spannungsquelle 19 an die Gate-Elektrode und Source-Elektrode angelegt wird.

Beim Leitendsteuern des Thyristors 1 fließt ein Strom von der Klemme 4 über den IGFET 2, den Thyristor 1 und den IGFET 3 zur Klemme 5. Die Schwellwertglieder sind stromlos, da der Spannungsabfall zwischen der Klemme 4 und der Zone 6 bzw. der Zone 8 und der Klemme 5 kleiner als die Schwellspannung dieser Schwellwertglieder sind.

Soll der Thyristor 1 ausgeschaltet werden, so werden zunächst die IGFET 2 und 3 durch ein entsprechendes Signal gesperrt. Damit werden die Zonen 7 und 9 von der Spannung $+U_B$ getrennt. Die Schwellwertglieder 10 und 11 führen jetzt Strom und die in den Zonen 6 und 8 gespeicherten Ladungsträger werden unmittelbar durch die an den Anschlüssen dieser Zonen liegende Spannung ausgeräumt. Hierbei können keine Ladungsträger aus den Zonen 7 und 9 in die Zonen 6 bzw. 8 injiziert werden, da die äußeren Zonen von der Spannung abgeschaltet sind. Damit muß nur diejenige Menge an Ladungsträgern aus dem Thyristor ausgeräumt werden, die bei Sperren der IGFET 2 und 3 in den Zonen 6 und 8 gespeichert war. Die Anzahl der gespeicherten Ladungsträger beträgt damit nur einen Bruchteil der beim Abschalten eines üblichen Thyristors auszuräumenden Ladungsträger. Wie groß dieser Bruchteil ist, hängt vom Verhältnis der Dotierungen zwischen den Zonen 7 und 6 bzw. 9 und 8 ab.

Die Weiterbildung des in Fig. 1 dargestellten elektronischen Schalters nach Fig. 2 enthält zusätzlich zwei Kondensatoren 21 und 22, die den Schwellwertgliedern 10 bzw. 11 parallel geschaltet sind. Beim Abschalten des elektronischen Schalters nach Fig. 2 werden diese Kondensatoren auf die Schwellspannung der Schwellwertglieder 10, 11 bzw. 12, 13 aufgeladen. Soll der Thyristor 1 dann wieder gezündet werden, so genügt es, die beiden IGFET 2 und 3 einzuschalten. Dann fließt der Entladestrom des Kondensators 21 in die Zone 6 und der Entladestrom des Kondensators 22 zur Zone 8. Damit wird der zwischen den Zonen 6 und 8 liegende, gesperrte pn-Übergang in Durchlaßrichtung vorgespannt und der Thyristor kann zünden. Zum Abschalten werden wiederum die IGFET 2 und 3 gesperrt. Für das Ansteuern der IGFET 2 und 3 können die gleichen Mittel verwendet werden wie für den elektronischen Schalter nach 1 beschrieben. Eine separate Zündstromquelle für den Thyristor 1 entfällt hier jedoch.

## Patentansprüche

1. Elektronischer Schalter mit einem Thyristor mit vier Zonen abwechselnden Leitungstyps, dem katodenseitig ein erster IGFET in Reihe geschaltet ist, gekennzeichnet durch die Merkmale:
   a) dem Thyristor (1) ist anodenseitig ein zweiter IGFET (2) in Reihe geschaltet,
   b) der zweite IGFET (2) ist zwischen der äußeren anodenseitigen Zone (7) und einer ersten Klemme (4) des Schalters angeschlossen,
   c) der erste IGFET (3) ist zwischen der äußeren katodenseitigen Zone (9) und einer zweiten Klemme (5) des Schalters angeschlossen,
   d) die innere anodenseitige und die innere katodenseitige Zone (8) sind mit je einem Anschluß versehen,
   e) zwischen dem Anschluß der inneren anodenseitigen Zone (6) und der ersten Klemme (4) ist ein erstes Schwellwertglied (10) angeschlossen,
   f) zwischen dem Anschluß der inneren katodenseitigen Zone (8) und der zweiten Klemme (5) ist ein zweites Schwellwertglied (11) angeschlossen,
   g) die Schwellwertglieder (10, 11) haben eine höhere Schwellspannung als die pn-Übergänge zwischen den beiden anodenseitigen (7, 6) bzw. katodenseitigen Zonen (9, 8) zuzüglich des Durchlaßwiderstandes des mit der äußeren anodenseitigen (7) bzw. katodenseitigen Zone (9) verbundenen IGFET (2, 3).

2. Elektronischer Schalter nach Anspruch 1, dadurch gekennzeichnet, daß jedem Schwellwertglied ein Kondensator (21, 22) parallel geschaltet ist.

3. Elektronischer Schalter nach Anspruch 1, dadurch gekennzeichnet, daß das Schwellwertglied (10, 11) aus in Reihe geschalteten Dioden besteht.

4. Elektronischer Schalter nach Anspruch 1, dadurch gekennzeichnet, daß das Schwellwertglied (12, 13) eine Zenerdiode ist.

## Claims

1. An electronic switch including a thyristor having four zones of alternate conductivity type, and connected by its cartode in series with a first IGFET, characterised by the following features:
   a) the thyristor (1) is connected in series with a second IGFET (2) by its anode;
   b) the second IGFET (2) is connected between the outer zone (7) of the anode and a first terminal (4) of the switch;
   c) the first IGFET (3) is connected between the outer zone (9) of the cathode and a second terminal (5) of the switch;
   d) the inner zone of the anode and the inner zone (8) of the cathode are each provided with a terminal;
   e) a first threshold-value element (10) is connected between the terminal of the inner zone (6) of the anode and the first terminal (4);
   f) a second threshold-value element (11) is connected between the terminal of the inner zone (8) of the cathode and the second terminal (5);
   g) the threshold-value elements (10, 11) have a higher threshold voltage than the pn-junctions between the two zones (7,6) of the anode and zones (9, 8) of the cathode plus the conductive-state d.c. resistance of the respective IGFET (2, 3) connected to the outer zone (7) of the anode and zone (9) of the cathode.

2. An electronic switch as claimed in Claim 1, characterised in that a respective capacitor (21, 22) is connected in parallel to each threshold-value element.

3. An electronic switch as claimed in Claim 1, characterised in that each threshold-value element (10, 11) consists of a plurality of series-connected diodes.

4. An electronic switch as claimed in Claim 1, characterised in that each threshold-value element (12, 13) is a Zener diode.


**Revendications**

1. Interrupteur électronique comportant un thyristor, qui comprend quatre zones possédant des types de conductivité alternés et en série avec lequel se trouve branché, côté cathode, un premier transistor IGFET, caractérisé par les moyens suivants:

a) un second transistor IGFET (2) est branché en série avec le thyristor (1), sur le côté anode de ce dernier,

b) le second transistor IGFET (2) est branché entre la zone extérieure (7) située du côté de la cathode et une première borne (4) de l'interrupteur,

c) le premier transistor IGFET (3) est branché entre la zone extérieure (9), située du côté de la cathode et une seconde borne (5) de l'interrupteur ,

d) la zone intérieure (8) située du côté de l'anode et la zone intérieure (8) située du côté de la cathode sont munies de bornes respectives,

e) un premier circuit à valeur de seuil (10) est branché entre le raccord de la zone intérieure (6) située du côté de l'anode et la première borne (4),

f) un second circuit à valeur de seuil (11) est branché entre le raccord de la zone intérieure (8) situge du côté de la cathode et de la seconde borne (5),

g) les circuits à valeur de seuil (10, 11) possèdent une tension de seuil supérieure à la tension de seuil des jonctions pn situées entre les deux zones (7, 6) situées du côté de l'anode ou les deux zones (9, 8) situées du côté de la cathode, à laquelle est ajoutée la résistance à l'état passant du transistor IGFET (2, 3) relié à la zone extérieure (7) située du côté de l'anode ou à la zone extérieure (9) située du côté de la cathode.

2. Interrupteur électronique selon la revendication 1, caractérisé en ce qu'un condensateur (21, 22) est branché en parallèle avec chaque circuit à valeur de seuil.

3. Interrupteur électronique suivant la revendication 1, caractérisé par le fait que le circuit à valeur de seuil (10, 11) est constitué par des diodes branchées en série.

4. Interrupteur électronique selon la revendication 1, caractérisé par le fait que le circuit à valeur de seuil (12, 13) est une diode Zener.

FIG 1

FIG 2